# DEMANDE DE BREVET EUROPEEN

(11) **EP 3 502 639 A1**
(43) Date de publication de la demande: **26.06.2019**
(21) Numéro de dépôt: 18214872.6
(22) Date de dépôt: 20.12.2018
(51) Int. Cl.: G01J 5/34, G06K 9/00

(54) **CAPTEUR PYROELECTRIQUE AVEC BLINDAGE ÉLECTRO-MAGNÉTIQUE AMÉLIORÉ**

(30) Priorité: 22.12.2017 FR 1762925
(71) Demandeur: Commissariat à l'Energie Atomique et aux Energies Alternatives (CEA), 75015 Paris (FR)
(72) Inventeur: BENWADIH, Mohammed, 94500 CHAMPIGNY SUR MARNE (FR); MAINGUET, Jean-François, 38100 GRENOBLE (FR); REVAUX, Amélie, 38500 VOIRON (FR); TOURNON, Laurent, 38120 SAINT-EGREVE (FR)
(74) Mandataire: Brevalex

(57) **Abrégé**

L'invention concerne un capteur de motifs thermiques (100) comportant une matrice de capacités pyroélectriques.

Le capteur comporte en outre un étage de blindage électromagnétique (140), électriquement conducteur, situé entre un étage (130) comprenant un matériau pyroélectrique et une couche de protection (180) de la matrice de pixel.

L'étage de blindage électromagnétique (240) comprend une couche d'isolation, et une pluralité de plots répartis dans la couche d'isolation, les plots présentant une conductivité thermique supérieure à celle de la couche d'isolation.

L'invention permet d'obtenir à la fois des transferts de chaleur rapides à travers l'étage de blindage électromagnétique, et de faibles transferts latéraux de chaleur, d'un pixel à l'autre du capteur.

## Description

### DOMAINE TECHNIQUE

L'invention se rapporte à un capteur de motifs thermiques de type capteur pyroélectrique.

Un tel capteur forme par exemple un capteur d'empreinte papillaire, notamment un capteur d'empreinte digitale.

### ÉTAT DE LA TECHNIQUE ANTÉRIEURE

Un capteur pyroélectrique exploite les propriétés de pyroélectricité d'un matériau, c'est-à-dire sa capacité à générer des charges électriques en réponse à une variation de température.

Un tel capteur comporte une matrice de capacités pyroélectriques, formant chacune un transducteur pour traduire une variation temporelle de température en un signal électrique.

Chaque capacité pyroélectrique comporte une portion en matériau pyroélectrique, disposée entre une électrode inférieure et une électrode supérieure. L'une des électrodes est mise à un potentiel constant, et forme une électrode de référence. L'autre électrode, nommée électrode de collecte de charges, collecte des charges pyroélectriques générées par le matériau pyroélectrique en réponse à une variation de température. L'électrode de collecte de charges est connectée à un circuit de lecture, pour mesurer la quantité de charges collectée.

En fonctionnement, un objet est appuyé contre une surface de contact du capteur.

La détection peut exploiter simplement une différence de température entre cet objet et ladite surface de contact. Le capteur réalise alors une détection de type passif.

Dans le cas d'une détection d'empreinte digitale, le doigt est appuyé contre la surface de contact du capteur.

Au niveau des crêtes de l'empreinte, le doigt est en contact physique direct avec le capteur. Un transfert thermique entre la peau et la surface de contact du capteur s'effectue par conduction, ce qui conduit à une première variation temporelle de température.

Au niveau des vallées de l'empreinte, le doigt n'est pas en contact physique direct avec le capteur. Un transfert thermique entre la peau et la surface de contact du capteur s'effectue à travers l'air. L'air présente des propriétés d'isolant thermique, ce qui conduit à une seconde variation temporelle de température, moins importante.

La différence entre ces deux variations temporelles de température se traduit par une différence entre les signaux mesurés par les capacités pyroélectriques, selon qu'elles se trouvent sous une vallée ou sous une crête de l'empreinte. L'image de l'empreinte présente alors un contraste qui dépend de cette différence.

Après quelques secondes, la température du doigt et la température de la surface de contact s'homogénéisent, et il n'est plus possible d'obtenir un contraste satisfaisant.

Pour pallier à cet inconvénient, on ajoute des moyens de chauffage sous la surface de contact, pour dissiper une certaine quantité de chaleur dans chaque pixel du capteur. La variation de température mesurée dans chaque pixel du capteur se rapporte alors à la mesure dans laquelle cette quantité de chaleur est évacuée du pixel. Cela permet d'améliorer et de conserver au cours du temps, le contraste d'une image acquise à l'aide dudit capteur. Le capteur réalise alors une détection de type actif. Un tel capteur est décrit par exemple dans la demande de brevet EP 2 385 486.

Dans le cas d'une détection d'empreinte digitale, la variation de température est importante au niveau des vallées de l'empreinte, où la chaleur n'est transférée au doigt qu'à travers l'air, et plus faible au niveau des crêtes de l'empreinte, où la chaleur est transférée efficacement au doigt, par conduction.

Quel que soit le type de détection mis en oeuvre, un capteur pyroélectrique comporte avantageusement un étage dit de blindage électromagnétique, c'est-à-dire un étage électriquement conducteur, apte à être connecté à une source de potentiel constant, et formant un blindage électromagnétique entre un objet à imager appliqué contre la surface de contact du capteur, et les portions en matériau pyroélectrique des pixels du capteur. L'étage de blindage électromagnétique offre une protection à l'égard des parasites électrostatiques, notamment autour de 50 Hz, évitant la récupération de bruit électromagnétique dans les mesures réalisées. Il permet également de protéger le capteur à l'égard des décharges électrostatiques, apportées par le contact de l'objet à imager contre la surface de contact du capteur. Dans le cas d'un capteur d'empreinte papillaire, il offre une protection à l'égard des décharges électrostatiques, apportées par le contact avec la peau lorsque le doigt touche la surface de contact du capteur.

La demande de brevet français n° 16 57391, déposée le 29 juillet 2016, décrit un exemple d'un capteur pyroélectrique apte à réaliser une détection de type actif, et comportant un tel étage de blindage électromagnétique. L'étage de blindage électromagnétique y est constitué d'une simple couche en matériau électriquement conducteur.

L'étage de blindage électromagnétique s'étend entre la surface de contact du capteur, et les portions en matériau pyroélectrique des pixels du capteur, de préférence sous une couche de protection du capteur.

Afin de ne pas entraver les échanges de chaleur entre un objet à imager, appuyé contre ladite surface de contact, et les portions en matériau pyroélectrique, l'étage de blindage électromagnétique doit pouvoir transmettre la chaleur.

Cependant, si cet étage est constitué d'une couche d'un matériau présentant une trop forte conductivité thermique, on risque que la chaleur se propage latéralement dans l'étage de blindage électromagnétique, d'un pixel à l'autre du capteur. Ce phénomène, nommé diathermie, empêche qu'un motif thermique sur la surface de contact soit reproduit fidèlement au niveau des portions en matériau pyroélectrique.

A l'inverse, si cet étage est constitué d'une couche d'un matériau présentant une trop faible conductivité thermique, les échanges de chaleur à travers cet étage sont ralentis, ralentissant également la lecture des pixels du capteur. Cette lecture plus lente peut poser des difficultés, en particulier pour des capteurs de grandes dimensions.

Un objectif de la présente invention est de proposer une solution pour que l'étage de blindage électromagnétique d'un capteur pyroélectrique offre une grande vitesse de transfert de la chaleur, tout en limitant les transferts de chaleur d'un pixel à l'autre du capteur.

### EXPOSÉ DE L'INVENTION

Cet objectif est atteint avec un capteur de motifs thermiques comportant une matrice de pixels, chaque pixel comportant au moins une capacité pyroélectrique, formée par une portion en matériau pyroélectrique disposée entre une électrode dite de collecte de charges et une électrode dite de référence, et la matrice de pixels comportant, superposés au-dessus d'un substrat :
- un étage d'électrodes de collecte de charges, comportant les électrodes de collecte de charge de chacun des pixels ;
- un étage comprenant un matériau pyroélectrique, comportant les portions en matériau pyroélectrique de chacun des pixels ; et
- une couche de protection, formant une couche externe de la matrice de pixels.

La matrice de pixels comporte en outre un étage dit de blindage électromagnétique, électriquement conducteur, situé entre l'étage comprenant un matériau pyroélectrique et la couche de protection.

Selon l'invention, l'étage de blindage électromagnétique comprend une couche, dite couche d'isolation, et une pluralité de plots répartis dans la couche d'isolation. Chaque plot s'étend sur plus de la moitié de l'épaisseur de la couche d'isolation et présente un diamètre inférieur à un pas de pixel de la matrice de pixels. Les plots présentent une conductivité thermique supérieure à celle de la couche d'isolation.

En d'autres termes, les plots présentent une conductivité thermique élevée, et s'étendent dans une couche d'isolation présentant une faible conductivité thermique.

Grâce à leur conductivité thermique élevée, la chaleur se propage rapidement dans les plots, en particulier selon un axe orthogonal au plan du substrat.

La chaleur se propage également latéralement dans chaque plot, dans des plans parallèles au plan du substrat. Cependant, chaque plot s'étend dans la couche d'isolation, de faible conductivité thermique, ce qui limite la diffusion de chaleur d'un plot à l'autre de l'étage de blindage électromagnétique, et ainsi d'un pixel à l'autre de la matrice de pixels.

L'étage de blindage électromagnétique selon l'invention offre ainsi à la fois :
- des transferts thermiques rapides, selon un axe orthogonal au plan du substrat ; et
- une faible diffusion latérale de la chaleur, d'un pixel à l'autre du capteur.

De préférence, chaque plot s'étend dans un unique pixel de la matrice de pixels, sans dépasser, même à la marge, sur un pixel voisin.

Le cas échéant, l'étage de blindage électromagnétique selon l'invention peut former en outre les électrodes de référence des pixels de la matrice de pixels. En variante, les électrodes de référence s'étendent dans un étage du capteur distinct de l'étage de blindage électromagnétique.

De préférence, chaque pixel de la matrice de pixels comporte une portion de l'étage de blindage électromagnétique, ladite portion recevant un unique plot.

Les plots de l'étage de blindage électromagnétique présentent avantageusement une conductivité thermique au moins dix fois supérieure à celle de la couche d'isolation.

Les plots peuvent comprendre du métal ou du graphène, et la couche d'isolation peut comprendre au moins un polymère électriquement conducteur. Les plots peuvent même être constitués de métal ou de graphène.

En particulier, les plots peuvent comprendre de l'argent, et la couche d'isolation peut comprendre un mélange de poly(3,4-éthylènedioxythiophène) et de poly(styrène sulfonate) de sodium, nommé PEDOT : PSS.

De préférence, les plots s'enfoncent chacun sur plus de la moitié de l'épaisseur de la couche d'isolation.

Les plots s'enfoncent avantageusement chacun sur toute l'épaisseur de la couche d'isolation.

Les plots peuvent présenter chacun un diamètre compris entre 10 µm et 120 µm, le diamètre d'un plot étant la plus grande longueur mesurée selon un axe rectiligne, sur ce plot, dans un plan parallèle à une face supérieure ou inférieure du substrat.

Selon un mode de réalisation avantageux :
- chaque pixel comporte en outre un élément de chauffage, apte à chauffer par effet Joule la portion en matériau pyroélectrique dudit pixel ; et
- un étage de chauffage, comportant les éléments de chauffage de chacun des pixels, s'étend dans la matrice de pixels entre l'étage comprenant un matériau pyroélectrique et la couche de protection.

Selon une variante de ce mode de réalisation avantageux :
- les éléments de chauffage d'une même ligne de pixels sont formés ensemble d'un seul tenant, en une même bande de chauffage ;
- les électrodes de collecte de charges d'une même colonne de pixels sont formées ensemble d'un seul tenant, en une même macro-électrode de collecte de charges ; et
- chaque plot de l'étage de blindage électromagnétique s'étend à travers une région d'intersection entre une projection d'une bande de chauffage et une projection d'une macro-électrode de collecte de charges, lesdites projections étant des projections orthogonales dans un plan parallèle à une face supérieure ou inférieure du substrat.

La matrice de pixels peut comporter, superposés :
- l'étage d'électrodes de collecte de charges ;
- l'étage comprenant un matériau pyroélectrique ;
- l'étage de blindage électromagnétique, formant en outre les électrodes de référence des pixels de la matrice de pixels ;
- une couche d'isolation électrique ;
- l'étage de chauffage ; et
- la couche de protection.

En variante, la matrice de pixels peut comporter, superposés :
- l'étage d'électrodes de collecte de charges ;
- l'étage comprenant un matériau pyroélectrique ;
- l'étage de chauffage, les éléments de chauffage formant en outre les électrodes de référence des pixels de la matrice de pixels ;
- une couche d'isolation électrique ;
- l'étage de blindage électromagnétique ; et
- la couche de protection.

L'invention concerne également un procédé de fabrication de la matrice de pixels d'un capteur de motifs thermiques selon l'invention, dans lequel une étape de réalisation de l'étage de blindage électromagnétique comprend les étapes suivantes :
- dépôt de la couche d'isolation, de sorte qu'elle s'étende sans ouverture au-dessus du substrat ;
- dépôt, sur ladite couche d'isolation, d'une encre comprenant des particules en suspension dans un solvant, le solvant étant apte à dissoudre localement la couche d'isolation ; et
- évacuation du solvant, pour former les plots de l'étage de blindage électromagnétique, répartis dans la couche d'isolation.

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :
- les figures 1A et 1B illustrent de manière schématique un premier mode de réalisation d'un capteur de motifs thermiques selon l'invention ;
- la figure 1C illustre une variante du mode de réalisation des figures 1A et 1B ;
- les figures 2A et 2B illustrent de manière schématique un deuxième mode de réalisation d'un capteur de motifs thermiques selon l'invention ;
- la figure 2C illustre une variante du mode de réalisation des figures 2A et 2B ; et
- les figures 3A à 3C illustrent de manière schématique un procédé selon l'invention.

### EXPOSÉ DÉTAILLÉ DE MODES DE RÉALISATION PARTICULIERS

Pour plus de clarté, on a représenté sur les figures les axes (Ox), (Oy) et/ou (Oz) d'un repère orthonormé. Les échelles ne sont pas respectées sur les figures, en particulier, les épaisseurs de chacun(e) des couches et/ou étages.

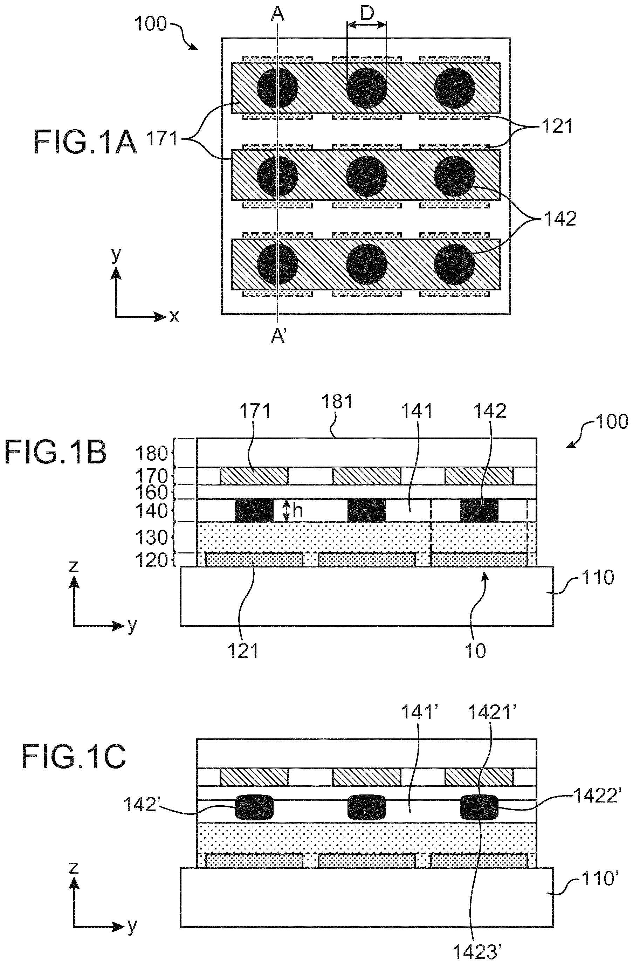

Les figures 1A et 1B illustrent de manière schématique un premier mode de réalisation d'un capteur de motifs thermiques 100 selon l'invention. La figure 1A est une vue schématique de dessus, dans un plan parallèle au plan (xOy). La figure 1B est une vue en coupe dans un plan AA' parallèle au plan (yOz).

Le capteur de motifs thermiques 100 comporte, superposés au-dessus d'un substrat 110, selon l'axe (Oz) orthogonal à une face supérieure ou inférieure dudit substrat :
- un étage 120 nommé étage d'électrodes de collecte de charges ;
- un étage 130 comprenant un matériau pyroélectrique ;
- un étage 140 de blindage électromagnétique ;
- une couche d'isolation électrique 160 ;
- un étage de chauffage 170 ; et
- une couche de protection 180.

Cet empilement forme une matrice de pixels, dans laquelle chaque pixel comporte au moins une capacité pyroélectrique, formée par une portion en matériau pyroélectrique disposée entre une électrode de collecte de charge, et une électrode de référence. Dans ce mode de réalisation, l'étage 140 de blindage électromagnétique forme également une électrode de référence commune à tous les pixels de la matrice de pixels.

Le substrat 110 est par exemple en verre, en silicium, en un pastique tel que le poly(téréphtalate d'éthylène) (PET), en poly(naphtalate d'éthylène) (PEN), en polyimide (film Kapton), etc. Il s'agit de préférence d'un substrat souple, par exemple un substrat en polyimide de 5 µm à 10 µm d'épaisseur, ou en un plastique tel que le PET.

Il présente une face supérieure et une face inférieure parallèles entre elles, et parallèles au plan (xOy). Dans la suite, le plan du substrat désigne un plan parallèle à ces faces inférieure et supérieure.

L'étage d'électrodes de collecte de charges 120 comporte ici une matrice d'électrodes de collecte de charges 121, disposées en lignes et en colonnes selon les axes (Ox) et (Oy).

Les électrodes de collecte de charges sont constituées d'un métal tel que l'or ou l'argent, ou tout autre matériau électriquement conducteur.

Elles sont réparties selon les axes (Ox) et (Oy), selon un pas de répartition inférieur ou égal à 150 µm. Le pas de répartition est par exemple de 80 µm environ (soit une résolution de 320 dpi), ou 90 µm. En variante, le pas de répartition peut être de 50,8 µm (soit une résolution de 500 dpi).

Chacune des électrodes de collecte de charges 121 délimite ici, latéralement, la capacité pyroélectrique 10 de l'un des pixels de la matrice de pixels (voir figure 1B).

L'étage 130 comprenant un matériau pyroélectrique est constitué ici d'une pleine couche comprenant du poly(fluorure de vinylidène) (PVDF) ou l'un de ses dérivés (notamment le copolymère PVDF-TrFE, TrFE pour Tri-fluoro-éthylène).

En variante, la couche 130 comprend du nitrure d'aluminium (AIN), du titanate de baryum (BaTiO₃), du Titano-Zirconate de Plomb (PZT), ou tout autre matériau pyroélectrique.

La couche 130 s'étend d'un seul tenant, et sans ouverture, en recouvrant l'ensemble des électrodes de collecte de charges 121 de l'étage 120.

Chaque portion de la couche 130, située au regard d'une électrode de collecte de charges 121, forme la portion en matériau pyroélectrique d'un pixel de la matrice de pixels.

L'étage 140 de blindage électromagnétique forme un étage électriquement conducteur, présentant ici une structure hétérogène, décrite ci-après.

Il est apte à être connecté à une source de potentiel constant, par exemple à la masse.

L'étage 140 s'étend de préférence d'un seul tenant, et sans ouverture, au-dessus de l'ensemble des électrodes de collecte de charges 121 de l'étage 120, c'est-à-dire en passant par tous les pixels de la matrice de pixels.

Ici, l'étage 140 forme également une électrode de référence, commune à tous les pixels de la matrice de pixels. En d'autres termes, chaque portion de l'étage 140, située au regard d'une électrode de collecte de charges 121, forme l'électrode de référence d'un pixel de la matrice de pixels.

La couche d'isolation électrique 160 est constituée d'un matériau diélectrique, par exemple du polyimide. Elle présente de préférence une épaisseur inférieure à 5 µm, par exemple égale à 1 µm.

Selon le mode de réalisation des figures 1A et 1B, chaque pixel de la matrice de pixels comporte en outre un élément de chauffage, les éléments de chauffage s'étendant ici dans l'étage de chauffage 170.

Ici, les éléments de chauffage d'une même ligne de pixels sont reliés électriquement entre eux pour former une bande de chauffage 171. Les bandes de chauffage 171 sont aptes à recevoir un courant de chauffage, pour fournir un chauffage par effet Joule, de manière à réaliser une détection de type actif. Elles sont constituées de préférence d'un métal, par exemple de l'or ou de l'argent.

La couche de protection 180 forme la couche la plus externe du capteur. Elle permet de limiter l'usure liée à des contacts répétés avec un objet à imager, notamment avec la peau. La couche de protection 180 est par exemple une couche en DLC (Diamond Like Carbon), en résine, en polyimide, etc. Elle présente généralement une épaisseur comprise entre quelques micromètres et 25 µm.

Une surface supérieure 181 de la couche de protection 180, du côté opposé au substrat 110, forme une surface de contact du capteur de motifs thermique 100. En fonctionnement, un objet à imager tel qu'une empreinte papillaire est appliqué contre ladite surface de contact 181, de manière à réaliser des échanges thermiques avec l'étage comprenant un matériau pyroélectrique.

Selon l'invention, l'étage 140 de blindage électromagnétique est constitué par :
- une couche d'isolation, 141, en matériau électriquement conducteur et mauvais conducteur thermique ; et
- une matrice de plots 142, en matériau électriquement conducteur et bon conducteur thermique.

La couche d'isolation 141 présente avantageusement une épaisseur inférieure ou égale à 1,5 µm, de préférence inférieure ou égale à 1,0 µm. Cette épaisseur vaut par exemple 600 nm.

La couche d'isolation 141 est constituée de préférence d'un matériau présentant une conductivité thermique inférieure ou égale à 10 W.m⁻¹K⁻¹.

De manière encore plus préférée, elle est constituée d'un matériau présentant une conductivité thermique inférieure ou égale à 1 W.m⁻¹K⁻¹.

Elle est, par exemple, en PEDOT :PSS (mélange de poly(3,4-éthylènedioxythiophène) (PEDOT) et le poly(styrène sulfonate) de sodium (PSS)), présentant une conductivité thermique de 0,3 W.m⁻¹K⁻¹. En variante, elle est en PEDOT.

Le PEDOT et le PEDOT :PSS ont pour avantage qu'ils peuvent être déposés sans nécessité d'une atmosphère contrôlée. Pour autant, d'autres matériaux ne sont pas exclus, tels que le poly(p-phénylène sulfide), le polypyrrole (PPY), le polythiophène (PT), le polyacétylène (PAC), la polyaniline (PAni), la mélanine.

La couche d'isolation 141 est électriquement conductrice. Pour autant, elle peut présenter une résistivité électrique supérieure à celle d'un métal, puisque la couche d'isolation 141 est destinée à supporter de faibles courants seulement. La couche d'isolation 141 présente par exemple une résistivité électrique comprise entre 10⁻⁸ Ω.m et 10⁻⁵ Ω.m (à 20°C), par exemple 5.10⁻⁵ Ω.m pour du PEDOT.

Les plots 142 sont constitués d'un matériau présentant une conductivité thermique supérieure ou égale à 50 W.m⁻¹K⁻¹.

De manière encore plus préférée, ils sont constitués d'un matériau présentant une conductivité thermique supérieure ou égale à 100 W.m⁻¹K⁻¹.

La conductivité thermique des plots 142 est de préférence au moins dix fois supérieure à celle de la couche d'isolation 141.

Les plots 142 comprennent par exemple un métal tel que l'argent, l'or, le cuivre, l'aluminium, etc. Ils sont par exemple réalisés à l'aide d'une encre à base d'un métal, en particulier une encre à base d'argent. Lorsque les plots sont réalisés à l'aide d'une encre à base d'un métal, ils sont constitués de particules de métal accolées les unes aux autres, avec un pourcentage d'occupation volumique par le métal plus ou moins élevé. Les plots présentent alors une conductivité thermique inférieure à celle du métal pur. Dans sa forme pure, l'argent présente une conductivité thermique de 429W.m⁻¹K⁻¹. Des plots réalisés à l'aide d'une encre à base d'argent présentent une conductivité thermique inférieure à 429W.m⁻¹K⁻¹ et supérieure ou égale à 69 W.m⁻¹K⁻¹, voire supérieure ou égale à 100 W.m⁻¹K⁻¹.

En variante, les plots 142 peuvent comprendre du graphène (matériau bidimensionnel dont l'empilement constitue le graphite, le graphite étant une forme cristallisée du carbone). Ils peuvent être entièrement constitués de graphène.

Les plots 142 sont électriquement conducteurs, avec une résistivité électrique comprise entre 10⁻⁸ Ω.m et 10-⁵ Ω.m (à 20°C). Pour les mêmes raisons qu'évoquées ci-dessus, des plots réalisés à l'aide d'une encre à base d'un métal présentent une résistivité électrique supérieure à celle du métal pur. Par exemple, l'argent dans sa forme pure présente une résistivité électrique de 1,57*10⁻⁸ Ω.m (à 20°C), tandis que des plots réalisés à l'aide d'une encre à base d'argent présentent une résistivité électrique comprise entre 3*10⁻⁷ Ω.m et 6*10⁻⁶ Ω.m, à 20°C.

Ici, les plots 142 sont répartis régulièrement, en lignes et en colonnes, de sorte que chaque pixel de la matrice de pixel comporte un seul et unique plot 142.

De préférence, le centre géométrique d'un plot 142 et le centre géométrique du pixel associé définissent ensemble un axe parallèle à l'axe (Oz).

Les plots 142 présentent par exemple une forme de cylindre de révolution, présentant :
- un diamètre *D* (dimension dans un plan parallèle au plan du substrat 110) ; et
- une hauteur *h* (dimension selon l'axe (Oz), orthogonal au plan du substrat 110).

Ici, chaque plot 142 s'étend, selon l'axe (Oz) orthogonal au plan du substrat, sur toute l'épaisseur de la couche d'isolation 141.

Chaque plot 142 présente ici une hauteur *h* égale à l'épaisseur de la couche d'isolation.

Cette épaisseur est ici inférieure à 1 µm, par exemple égale à 0,5 µm.

Le diamètre *D* est inférieur au pas de pixel de la matrice de pixels, de sorte que deux plots 142 voisins sont physiquement isolés l'un de l'autre, par une partie de la couche d'isolation 142.

Ce diamètre *D* est compris par exemple 10 µm et 100 µm, de préférence entre 50 µm et 60 µm.

Puisque chaque plot 142 présente une grande conductivité thermique, la chaleur circule rapidement dans le plot, selon toutes les dimensions de l'espace.

Selon l'axe (Oz), la chaleur circule donc rapidement à travers l'étage 140 de blindage électromagnétique, en passant par les plots 142.

En revanche, dans des plans parallèles au plan du substrat, la chaleur passe difficilement d'un plot 142 au plot voisin, et donc d'un pixel au pixel voisin, grâce à la faible conductivité thermique de couche d'isolation s'étendant entre les plots.

La structure hétérogène de l'étage de blindage électromagnétique 140 permet ainsi d'obtenir à la fois :
- des transferts thermiques rapides, selon un axe (Oz) orthogonal au plan du substrat ; et
- une faible diffusion latérale de la chaleur, d'un pixel à l'autre du capteur.

La figure 1C illustre, selon une vue en coupe dans un plan parallèle au plan (yOz), une variante du mode de réalisation des figures 1A et 1B.

Cette variante ne diffère de celle des figures 1A et 1B qu'en ce que les plots 142' ne s'étendent pas sur toute l'épaisseur de la couche d'isolation 141', et ne présentent pas tout à fait une forme de cylindre de révolution.

Selon cette variante, chaque plot 142' comporte :
- une région supérieure 1421', bombée, faisant saillie au-dessus de la face supérieure de la couche d'isolation 141', du côté opposé au substrat 110' ;
- un corps central 1422', en forme de cylindre de révolution ; et
- une région inférieure 1423', bombée, faisant saillie en direction du substrat depuis une face inférieure du corps central 1422', du côté du substrat 110'.

Les régions supérieure 1421' et inférieure 1423' ne dépassent pas latéralement, relativement au corps central 1422'. En outre, les régions supérieures 1421' ne dépassent que légèrement au-dessus de la face supérieure de la couche d'isolation 141', par exemple de moins de 500 nm selon l'axe (Oz) orthogonal à ladite face.

En tout état de cause, les plots 142' sont physiquement isolés les uns des autres, sans contact physique direct entre eux.

Le diamètre d'un plot 142' correspond ici au diamètre de son corps central cylindrique 1422'.

Le cas échéant, on peut définir le diamètre d'un plot comme étant la plus grande longueur mesurée selon un axe rectiligne, sur ce plot, dans un plan parallèle au plan du substrat.

Chaque plot 142' ne s'étend pas sur toute l'épaisseur de la couche d'isolation 141. Il s'étend cependant sur plus de la moitié de cette épaisseur, et même plus de 80% voire plus de 90% de cette épaisseur.

On peut alors distinguer deux sous-couches dans la couche d'isolation 141 :
- une sous-couche recevant les plots 142', dans laquelle on retrouve les avantages mentionnés ci-dessus, en référence aux figures 1A et 1B ; et
- une sous-couche ne recevant pas les plots, mais présentant une épaisseur réduite.

De préférence, les plots s'enfoncent dans la couche d'isolation depuis sa face supérieure, du côté opposé au substrat. La sous-couche ne recevant pas les plots s'étend alors du côté du substrat.

Selon d'autres variantes, non représentées, les plots présentent des sections non circulaires dans des plans parallèles au plan du substrat, par exemple des sections carrés ou rectangulaires, de côté compris par exemple entre 10 µm et 40 µm.

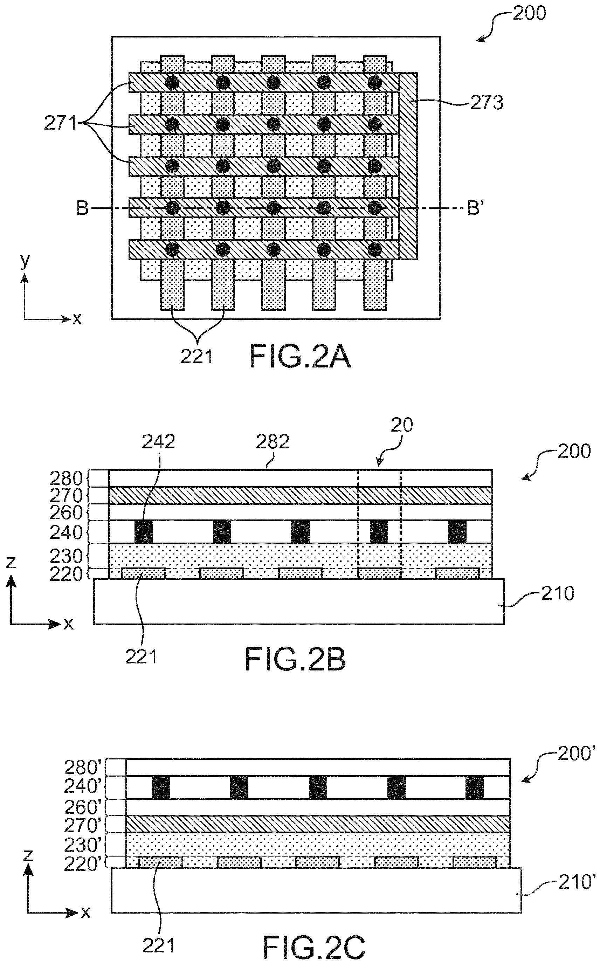

Les figures 2A et 2B illustrent de manière schématique un deuxième mode de réalisation d'un capteur de motifs thermiques 200 selon l'invention. La figure 2A est une vue schématique de dessus, dans un plan parallèle au plan (xOy). La figure 2B est une vue en coupe dans un plan BB' parallèle au plan (xOz).

Dans ce deuxième mode de réalisation, chaque pixel comporte un élément de chauffage, et ces éléments de chauffage sont mis à profit pour réaliser un adressage passif des pixels du capteur.

Les éléments de chauffage d'une même ligne de pixels sont reliés électriquement entre eux pour former une bande de chauffage 271. Chaque bande de chauffage 271 est configurée pour pouvoir être activée indépendamment des autres bandes de chauffage. En d'autres termes, les éléments de chauffage des pixels d'une même ligne de pixels sont aptes à chauffer les portions en matériau pyroélectrique des pixels de ladite ligne, indépendamment des éléments de chauffage des pixels des autres lignes. Les bandes de chauffage 271 présentent chacune une première extrémité, adaptée à être connectée à un potentiel électrique non nul, et une seconde extrémité, reliée de préférence à la masse. Ici, les secondes extrémités de toutes les bandes de chauffage sont reliées entre elles par l'intermédiaire d'une portion conductrice 273.

En outre, les électrodes de collecte de charges d'une même colonne de pixels sont reliées électriquement entre elles pour former une macro-électrode de collecte de charges 221. Chaque macro-électrode de collecte de charges 221 est formée par une bande électriquement conductrice, en contact avec les portions en matériau pyroélectrique des pixels de ladite colonne de pixels, et distincte des bandes électriquement conductrices formant les macro-électrodes de collecte de charges des autres colonnes de pixels.

Chaque macro-électrode de collecte de charges 221 permet de mesurer la somme des charges pyroélectriques, générées dans une même colonne de pixels. Si l'on n'active à chaque instant qu'une seule des bandes de chauffage 271, dans chaque colonne de pixels il n'y a qu'un seul pixel qui génère des charges pyroélectriques. Les charges pyroélectriques collectées par la macro-électrode de collecte de charges 221 se rapportent alors à cet unique pixel. On réalise ainsi un adressage passif des pixels du capteur.

Un tel capteur est décrit dans la demande de brevet français n° 16 57391, mentionnée en introduction.

Les termes « ligne » et « colonne » peuvent être échangés, ce qui correspondrait à une simple rotation à 90° du capteur.

Dans le mode de réalisation des figures 2A et 2B, le capteur de motifs thermiques 200 comporte, superposés dans cet ordre, au-dessus du substrat 210 :
- un étage 220 d'électrodes de collecte de charges, recevant les macro-électrodes de collecte de charge 221 ;
- un étage 230 comprenant un matériau pyroélectrique, identique à celui décrit en référence aux figures 1A et 1B ;
- un étage 240 de blindage électromagnétique, identique à celui décrit en référence aux figures 1A et 1B, ou à la figure 1C ;
- une couche 260 d'isolation électrique, telle que décrite en référence aux figures 1A et 1B ;
- un étage 270 dit étage de chauffage, recevant les bandes de chauffage 271; et
- une couche de protection 280, telle que décrite en référence aux figures 1A et 1B.

La surface de contact 281 du capteur est formée ici par une face supérieure de la couche de protection 280, du côté opposé au substrat 210.

L'étage 220 d'électrodes de collecte de charges est semblable à ce qui a été décrit en référence aux figures 1A et 1B, excepté que les électrodes de collecte de charges d'une même colonne de pixels sont formées ensemble d'un seul tenant. Elles sont réparties, selon l'axe (Ox), selon un pas de répartition inférieur ou égal à 150 µm, par exemple 90 µm, ou 80 µm, ou 50,8 µm.

Les bandes de chauffage 271 de l'étage de chauffage 270 sont réparties, selon l'axe (Oy), de préférence selon un pas de répartition identique au pas de répartition des macro-électrodes de collecte de charge 221. En tout état de cause, les bandes de chauffage 271 sont réparties de préférence selon un pas inférieur ou égal à 150 µm, par exemple 90 µm, ou 80 µm, ou 50,8 µm. Les bandes de chauffage 271 comprennent de préférence un métal, par exemple de l'or ou de l'argent.

Chaque pixel 20 de la matrice de pixel est délimité latéralement par l'intersection entre une macro-électrode de collecte de charges 221, et une bande de chauffage 271. En d'autres termes, chaque pixel est délimité latéralement, dans des plans parallèles au plan du substrat, par les contours de l'intersection entre la projection orthogonale, dans un tel plan, d'une macro-électrode de collecte de charges 221, et la projection orthogonale, dans ce même plan, d'une bande de chauffage 271.

Chaque pixel 20 reçoit un unique plot 242 de l'étage 240 de blindage électromagnétique. Ce plot s'étend donc, dans l'étage 240 de blindage électromagnétique, en traversant une région d'intersection située dans un plan parallèle au plan du substrat, à l'intersection entre une projection orthogonale d'une macro-électrode 221 et une projection orthogonale d'une bande de chauffage 271.

La figure 2C illustre une variante, qui ne diffère du mode de réalisation des figures 2A et 2B qu'en ce que l'étage de blindage électromagnétique s'étend au-dessus de l'étage de chauffage.

En particulier, le capteur de motifs thermiques 200' comporte, superposés dans cet ordre au-dessus du substrat 210' :
- l'étage 220' d'électrodes de collecte de charges ;
- l'étage 230' comprenant un matériau pyroélectrique ;
- l'étage de chauffage 270' ;
- la couche 260' d'isolation électrique ;
- l'étage 240' de blindage électromagnétique ; et
- la couche de protection 280', distincte de l'étage 240' de blindage électromagnétique.

Selon cette variante, chaque ligne de chauffage de l'étage de chauffage 270' forme également une électrode de référence, commune à tous les pixels d'une ligne de pixels de la matrice de pixels. Ladite ligne de chauffage est apte à être connectée à une source de potentiel, elle-même adaptée à faire circuler un courant non nul dans la ligne de chauffage. Ce courant doit rester constant pendant la lecture des charges sur les électrodes de collecte de charge des pixels associés. Lorsque l'autre côté de la ligne de chauffage est connecté à la masse, ladite source de potentiel alterne avantageusement entre deux valeurs constantes : une valeur nulle où la ligne de chauffage ne chauffe pas, et une valeur non nulle où la ligne de chauffage fournit un chauffage par effet Joule.

En variante, l'étage de chauffage 270' comporte des couples de deux bandes parallèles entre elles, l'une dédiée au chauffage d'une ligne de pixels, et l'autre formant une électrode de référence commune pour les pixels de la même ligne de pixels.

Selon des variantes non représentées du mode de réalisation des figures 2A et 2B, et du mode de réalisation de la figure 2C, les électrodes de collecte de charge d'une même colonne de pixels ne sont pas reliées entre elles, et l'adressage des pixels est de type actif et requiert des moyens de sélection dans chaque pixel, tels que des transistors.

L'invention n'est pas limitée aux exemples décrits ci-dessus, et de nombreuses variantes peuvent être mises en oeuvre sans sortir du cadre de l'invention.

En particulier, l'invention s'applique à tout type de capteur thermique comportant une matrice de capacités pyroélectriques, avec ou sans éléments de chauffage, avec des éléments de chauffage distincts ou agencés en bandes de chauffage parallèles entre elles.

L'invention s'applique plus particulièrement à des capteurs dans lesquels une distance entre la surface de contact et le plan des faces supérieures des électrodes inférieures des capacités pyroélectriques, et inférieure ou égale au pas de pixel du capteur.

Le capteur de motifs thermiques selon l'invention peut comporter des éléments de chauffage qui ne sont pas reliés entre eux selon des lignes de chauffage.

L'invention n'est pas non plus limitée à une détection de type actif, et couvre également des capteurs adaptés à une détection de type passif, sans élément de chauffage pour chauffer les portions en matériau pyroélectrique des pixels du capteur.

Lorsque les dimensions du pixel le permettent, chaque pixel de la matrice de pixels peut comporter une pluralité de plots de l'étage de blindage électromagnétique.

Dans tous les modes de réalisation, l'étage de blindage électromagnétique s'étend entre l'étage comprenant un matériau pyroélectrique et la couche de protection. Pour autant, des étages intercalaires peuvent être situées entre l'étage de blindage électromagnétique et l'étage comprenant un matériau pyroélectrique, respectivement entre l'étage de blindage électromagnétique et la couche de protection. En tout état de cause, la couche de protection forme une couche distincte de l'étage de blindage électromagnétique.

Le capteur peut inclure au moins un circuit de lecture, pour mesurer une quantité de charges collectée par une électrode de collecte de charges, et, le cas échéant, au moins un circuit de pilotage du chauffage, pour l'envoi de signaux électriques permettant de chauffer les pixels du capteur par l'intermédiaire des éléments de chauffage. Il peut comporter, en outre, un circuit électronique de traitement apte à construire une image globale d'un motif thermique, à partir de mesures réalisées au niveau de chacun des pixels du capteur.

Le motif thermique pouvant être imagé par le capteur peut être une empreinte papillaire, ou tout autre motif associé à un objet ayant une capacité thermique et une chaleur massique.

L'étage de blindage électromagnétique peut être réalisé en formant une matrice de plots, sur laquelle on dépose la couche d'isolation de sorte que le matériau de la couche d'isolation s'insère entre les plots.

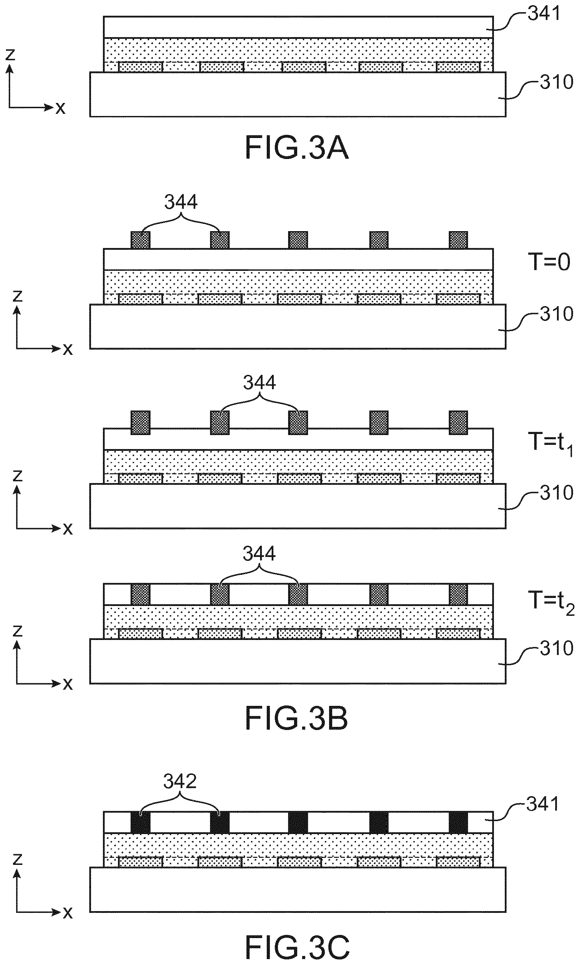

On décrit ci-après, en référence aux figures 3A à 3C, un procédé selon l'invention, plus astucieux, pour fabriquer l'étage de blindage électromagnétique d'un capteur de motifs thermiques selon l'invention. Ce procédé comporte les étapes suivantes :

### Etape 1 :

Dépôt de la couche d'isolation 341, de sorte qu'elle s'étende d'un seul tenant et sans ouverture au-dessus du substrat 310 (figure 3A).

Ici, mais de manière non limitative, la couche d'isolation 341 est déposée sur l'étage comprenant un matériau pyroélectrique.

### Etape 2 :

Dépôt, sur la couche d'isolation 341, d'une encre comportant, en suspension dans un solvant, des particules d'un matériau de conductivité thermique supérieure à celle de la couche d'isolation. Il s'agit en particulier de particules de métal ou de graphène.

L'encre est déposée uniquement aux emplacements souhaités, selon les axes (Ox) et (Oy), des futurs plots de l'étage de blindage électromagnétique, les axes (Ox) et (Oy) définissant le plan du substrat.

Le dépôt d'une encre est réalisé par exemple par sérigraphie, ou par impression par jet d'encre, par héliogravure, par flexogravure, par offset gravure, etc.

Le solvant est apte à dissoudre la couche d'isolation 341, de sorte que l'encre, là où elle a été déposée, dissout localement la couche d'isolation et s'enfonce dans celle-ci.

A la figure 3B, on a illustré cette étape à l'instant T=0 de dépôt de l'encre, et aux instants ultérieurs T=t₁>0, et T=t₂>t₁. La figure 3B montre des plots 344, constitués d'une encre, s'enfoncer progressivement dans la couche d'isolation 341, selon l'axe (Oz) orthogonal au plan du substrat 310.

Par exemple, la couche d'isolation 341 comprend du PEDOT, et l'encre comprend des particules d'argent ou de graphène, en suspension dans un solvant tel que de l'eau, ou du cyclopentanone, ou du diméthysulfone (C₂H₆O₂S). De préférence, l'encre comporte entre 35% et 55% en volume de solvant, plus préférentiellement entre 40% et 50%.

De préférence, l'encre dissout localement la couche d'isolation 341 sur toute son épaisseur, jusqu'à atteindre la couche, ou l'étage, situé(e) sous la couche d'isolation 341.

### Etape 3 :

Dans une troisième étape, illustrée en figure 3C, l'encre est séchée, par exemple par chauffage dans une étuve, pour évacuer le solvant. Il ne reste alors que les particules de métal ou de graphène, qui forment dans la couche d'isolation 341 les plots 342 tels que décrits ci-avant.

Un tel procédé est avantageusement mis en oeuvre avec une couche d'isolation 341 d'épaisseur réduite, de préférence d'épaisseur inférieure ou égale à 1,5 µm, et même inférieure ou égale à 1,0 µm, et même inférieure ou égale à 700 nm.

## Revendications

1. Capteur de motifs thermiques (100 ; 200 ; 200') comportant une matrice de pixels, chaque pixel comportant au moins une capacité pyroélectrique, formée par une portion en matériau pyroélectrique disposée entre une électrode dite de collecte de charges (121) et une électrode dite de référence, et la matrice de pixels comportant, superposés au-dessus d'un substrat (110 ; 110' ; 210 ; 210' ; 310) :
- un étage (120 ; 220; 220') d'électrodes de collecte de charges, comportant les électrodes de collecte de charge de chacun des pixels ;
- un étage (130 ; 230; 230') comprenant un matériau pyroélectrique, comportant les portions en matériau pyroélectrique de chacun des pixels ; et
- une couche de protection (180 ; 280), formant une couche externe de la matrice de pixel ;
la matrice de pixels comportant en outre un étage dit de blindage électromagnétique (140 ; 240 ; 240'), électriquement conducteur, situé entre l'étage (130 ; 230 ; 230') comprenant un matériau pyroélectrique et la couche de protection (180 ; 280) ; **caractérisé en ce que** l'étage de blindage électromagnétique (140 ; 240 ; 240') est constitué par une couche, dite couche d'isolation (141 ; 141' ; 341), et une pluralité de plots (142 ; 142' ; 242 ; 342) répartis dans la couche d'isolation, les plots présentant une conductivité thermique supérieure à celle de la couche d'isolation, chaque plot (142 ; 142' ; 242 ; 342) s'étendant sur plus de la moitié de l'épaisseur de la couche d'isolation et présentant un diamètre inférieur à un pas de pixel de la matrice de pixels.

2. Capteur de motifs thermiques (100 ; 200 ; 200') selon la revendication 1, **caractérisé en ce que** chaque pixel de la matrice de pixels comporte une portion de l'étage de blindage électromagnétique (140 ; 240 ; 240'), ladite portion recevant un unique plot (142 ; 142' ; 242 ; 242' ; 342).

3. Capteur de motifs thermiques (100 ; 200 ; 200') selon la revendication 1 ou 2, **caractérisé en ce que** les plots (142 ; 142' ; 242 ; 242' ; 342) de l'étage de blindage électromagnétique présentent une conductivité thermique au moins dix fois supérieure à celle de la couche d'isolation (141 ; 141' ; 341).

4. Capteur de motifs thermiques (100 ; 200 ; 200') selon l'une quelconque des revendications 1 à 3, **caractérisé en ce que** les plots (142 ; 142' ; 242 ; 242' ; 342) comprennent du métal ou du graphène, et la couche d'isolation (141 ; 141' ; 341) comprend au moins un polymère électriquement conducteur.

5. Capteur de motifs thermiques (100 ; 200 ; 200') selon la revendication 4, **caractérisé en ce que** les plots (142 ; 142' ; 242 ; 242' ; 342) comprennent de l'argent, et la couche d'isolation (141 ; 141' ; 341) comprend un mélange de poly(3,4-éthylènedioxythiophène) et de poly(styrène sulfonate) de sodium, nommé PEDOT : PSS.

6. Capteur de motifs thermiques (100 ; 200 ; 200') selon l'une quelconque des revendications 1 à 5, **caractérisé en ce que** les plots (142 ; 142' ; 242 ; 242' ; 342) s'enfoncent chacun sur plus de la moitié de l'épaisseur de la couche d'isolation (141 ; 141' ; 341).

7. Capteur de motifs thermiques (100 ; 200 ; 200') selon la revendication 6, **caractérisé en ce que** les plots (142 ; 242 ; 242' ; 342) s'enfoncent chacun sur toute l'épaisseur de la couche d'isolation (141 ; 341).

8. Capteur de motifs thermiques (100 ; 200 ; 200') selon l'une quelconque des revendications 1 à 7, **caractérisé en ce que** les plots (142 ; 142' ; 242 ; 242' ; 342) présentent chacun un diamètre compris entre 10 µm et 120 µm, le diamètre d'un plot étant la plus grande longueur mesurée selon un axe rectiligne, sur ce plot, dans un plan parallèle à une face supérieure ou inférieure du substrat.

9. Capteur de motifs thermiques (200 ; 200') selon l'une quelconque des revendications 1 à 8, **caractérisé en ce que** :
- chaque pixel comporte en outre un élément de chauffage, apte à chauffer par effet Joule la portion en matériau pyroélectrique dudit pixel ; et
- un étage de chauffage (270 ; 270'), comportant les éléments de chauffage de chacun des pixels, s'étend dans la matrice de pixels entre l'étage comprenant un matériau pyroélectrique (230 ; 230') et la couche de protection (180 ; 280).

10. Capteur de motifs thermiques (200 ; 200') selon la revendication 9, **caractérisé en ce que** :
- les éléments de chauffage d'une même ligne de pixels sont formés ensemble d'un seul tenant, en une même bande de chauffage (271) ;
- les électrodes de collecte de charges d'une même colonne de pixels sont formées ensemble d'un seul tenant, en une même macro-électrode de collecte de charges (221) ; et
- chaque plot (242) de l'étage de blindage électromagnétique (240 ; 240') s'étend à travers une région d'intersection entre une projection d'une bande de chauffage (271) et une projection d'une macro-électrode de collecte de charges (221), lesdites projections étant des projections orthogonales dans un plan parallèle à une face supérieure ou inférieure du substrat (210 ; 210').

11. Capteur de motifs thermiques (200) selon la revendication 9 ou 10, **caractérisé en ce que** la matrice de pixels comporte, superposés :
- l'étage d'électrodes de collecte de charges (220) ;
- l'étage comprenant un matériau pyroélectrique (230) ;
- l'étage de blindage électromagnétique (240), formant en outre les électrodes de référence des pixels de la matrice de pixels ;
- une couche d'isolation électrique (260) ;
- l'étage de chauffage (270) ; et
- la couche de protection (280).

12. Capteur de motifs thermiques (200') selon la revendication 9 ou 10, **caractérisé en ce que** la matrice de pixels comporte, superposés :
- l'étage d'électrodes de collecte de charges (220') ;
- l'étage comprenant un matériau pyroélectrique (230') ;
- l'étage de chauffage (270'), les éléments de chauffage formant en outre les électrodes de référence des pixels de la matrice de pixels ;
- une couche d'isolation électrique (260') ;
- l'étage de blindage électromagnétique (240') ; et
- la couche de protection (280').

13. Procédé de fabrication de la matrice de pixels d'un capteur de motifs thermiques (100 ; 200 ; 200') selon l'une quelconque des revendications 1 à 12, **caractérisé en ce qu'**une étape de réalisation de l'étage de blindage électromagnétique (140 ; 240 ; 240') comprend les étapes suivantes :
- dépôt de la couche d'isolation (341), de sorte qu'elle s'étende sans ouverture au-dessus du substrat (310) ;
- dépôt, sur ladite couche d'isolation, d'une encre (344) comprenant des particules en suspension dans un solvant, le solvant étant apte à dissoudre localement la couche d'isolation ; et
- évacuation du solvant, pour former les plots (342) de l'étage de blindage électromagnétique, répartis dans la couche d'isolation (341).
